# EUROPÄISCHE PATENTSCHRIFT

(11) **EP 3 552 466 B1**
(45) Veröffentlichungstag und Bekanntmachung des Hinweises auf die Patenterteilung: **18.05.2022**
(21) Anmeldenummer: 17808888.6
(22) Anmeldetag: 01.12.2017
(51) Int. Cl.: H05K 5/02, H05K 5/06

(54) **GEHÄUSETEIL FÜR EIN GEHÄUSE ELEKTRISCHER BAUTEILE**
HOUSING PART FOR A HOUSING OF ELECTRIC COMPONENTS
ÉLÉMENT DE BOÎTIER POUR BOÎTIER DE COMPOSANTS ÉLECTRIQUES

(30) Priorität: 08.12.2016 DE 102016123759
(43) Veröffentlichungstag der Anmeldung: 16.10.2019
(73) Patentinhaber: Phoenix Contact GmbH & Co KG, 32825 Blomberg (DE)
(72) Erfinder: BURY, Joachim, 92224 Amberg (DE); SALOMON, Thomas, 33415 Verl (DE)
(74) Vertreter: Patentship Patentanwaltsgesellschaft mbH
(86) Internationale Anmeldenummer: PCT/EP2017/081266
(87) Internationale Veröffentlichungsnummer: WO 2018/104184

(56) Entgegenhaltungen:
- WO-A1-2008/055597
- CN-U- 202 797 468
- US-A1- 2015 044 903

## Beschreibung

Die Erfindung betrifft ein Gehäuseteil für ein Gehäuse elektrischer Bauteile mit einer Anschlussvorrichtung, welche als Schnittstelle zu elektrischen Bauteilen innerhalb des Gehäuses ausgebildet ist.

Derartige Gehäuseteile oder Gehäuseausführungen elektrischer Bauteile umfassen meist mehrere feste Schnittstellen, welche für unterschiedliche Verschraubungen oder Leitungsdurchdringungen in das Gehäuse hinein oder aus dem Gehäuse heraus ausgebildet sind. Hierbei werden oft Universalgehäuse oder Gehäuseober- und Gehäuseunterschalen in Kombination mit zusätzlichen Anschlussverbindungen genutzt, um eine applikationsspezifische Varianz an den Schnittstellen zu ermöglichen. Hierbei wird jeweils eine gewünschte Schnittstelle durch Anordnen der entsprechenden geometrischen Anschlußkontur an eine dafür vorgesehene Stelle der Gehäuseschale bereitgestellt. Nachteilig ist bei diesem Prinzip jedoch, dass bei der Herstellung der Gehäuseteile viele verschiedene Werkzeugeinsätze für alle Ausführungsvarianten erforderlich sind.

Die Druckschrift US 2015/0044903 A1 beschreibt eine Abdeckplatte, die Teil eines Gehäuses eines elektronischen Gerätes bzw. einer Steuereinheit ist.

Die Druckschrift WO 2008/055597 A1 beschreibt eine Adaptervorrichtung für einen Spannungswandler für Mobilgeräte.

Die Druckschrift DE 299 22 206 U1 beschreibt ein Stecker-Kupplungssystem zum Anschluss eines von einem Gehäuse umgebenen elektrischen Bauteils, insbesondere eines Sensors.

Die Druckschrift DE 36 25 500 A1 beschreibt ein Frontsteckeranschlusssystem, bei dem in die Kontaktklammern eines Frontsteckergehäuses Verbindungselemente mit unterschiedlichen Anschlusstechniken eingebettet und arretiert werden können.

CN 202 797 468 U ist ein Gebrauchsmuster, das einen Netzteiladapter offenbart, der Stecker ersetzen kann.

Es ist die Aufgabe der vorliegenden Erfindung ein verbessertes Konzept für ein Gehäuseteil mit einer universellen Schnittstelle bereitzustellen.

Diese Aufgabe wird durch den Gegenstand mit den Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch ein Gehäuseteil für ein Gehäuse elektrischer Bauteile mit einer ersten universellen Anschlussvorrichtung, welche als Schnittstelle zu elektrischen Bauteilen innerhalb des Gehäuses ausgebildet ist, und einem anwendungsspezifischen Adapterflansch gelöst, welcher zum Anordnen an die erste Anschlussvorrichtung und als Schnittstelle zu den elektrischen Bauteilen innerhalb des Gehäuses ausgebildet ist. Dadurch wird beispielsweise der technische Vorteil erreicht, dass mit einer universellen Anschlussvorrichtung in Verbindung mit einem anwendungsspezifischen Adapterflansch aus einer Vielzahl von unterschiedlichen Adapterflanschen an einer einzigen Position eines Gehäuses für elektrische Bauteile jede gewünschte Schnittstelle hergestellt werden kann. Hierbei ist es besonders vorteilhaft, dass die Herstellung der entsprechenden Gehäuseteile mit einer einzigen universellen Schnittstelle preiswert und unter Einsatz weniger Werkzeugeinsätze möglich ist. Somit können die Gehäuseteile oder die Gehäuseteile werkzeugunabhängig den Anwendungsanforderungen entsprechend konfektioniert werden.

Um die Flexibilität der universellen Schnittstelle besonders stark auszubilden, ist der Adapterflansch austauschbar ausgebildet. Somit ist es möglich, an die erste Anschlussvorrichtung einen bevorzugten Adapterflansch anzuordnen, der dem jeweiligen Zweck einer Anwendung entspricht. Zusätzlich ist durch die Austauschbarkeit des Adapterflansches möglich, durch einen Wechsel des Adapterflansches den Zweck oder die Anwendung zu variieren.

Gemäß einer bevorzugten Ausführungsform, umfasst der Adapterflansch einen Anschraubsockel für Verschraubungen. Dadurch wird beispielsweise der technische Vorteil erreicht, dass eine sehr einfache und flexible Form der Anordnung des Adapterflanschs an der ersten Anschlussvorrichtung möglich ist.

Gemäß einer weiteren bevorzugten Ausführungsform, ist der Adapterflansch dazu ausgebildet, metrische Anschlussverschraubungen aufzunehmen. Beispielsweise können hier Verschraubungen der Größe M16, M20 oder M25 eingesetzt werden. Dadurch wird beispielsweise der technische Vorteil erreicht, dass die Verschraubungen mit bestehenden Werkzeugeinsätzen besonders einfach herstellbar sind. Somit kann für die Herstellung auf bestehende Mittel zurückgegriffen werden. Jedoch ist es hier ebenso denkbar, die Verschraubung mit anderen Größen oder Formaten zu versehen.

Um die Anordnung des Adapterflanschs besonders zuverlässig zu gestalten, ist der Adapterflansch als Anbaugehäuse für einen Steckverbinder ausgebildet. Besonders geeignet sind hier beispielsweise Industriesteckverbinder HC-Q5 oder HC-Q8. Derartige Steckverbinder sind zudem besonders robust gegenüber Feuchtigkeit, Hitze oder gegebenenfalls auftretenden Umwelteinflüssen.

Gemäß einer weiteren besonders bevorzugten Ausführungsform, ist der Adapterflansch dazu ausgebildet die erste Anschlussvorrichtung vollständig zu verschließen. Dadurch wird beispielsweise der technische Vorteil erreicht, dass ein elektrische Bauteile tragendes Gehäuse bedarfsweise vollständig verschlossen werden kann. Dies kann beispielsweise während der Montage des Gehäuses oder bei einem Austausch eines derartigen Gehäuses der Fall sein. Ferner kann ein derartiges Gehäuse für einen Transport zuverlässig verschlossen werden, wodurch die elektrischen Bauteile im Innenraum vor Feuchtigkeit geschützt werden können.

Um die Zuverlässigkeit und die Dichtheit der Verbindung zwischen der ersten Anschlussvorrichtung und dem Adapterflansch zu verbessern und insbesondere um das Eindringen von Feuchtigkeit zu verhindern, weist das Gehäuseteil ein Dichtelement auf um die erste Anschlussvorrichtung und den Adapterflansch gegeneinander abzudichten.

Gemäß einer bevorzugten Ausführungsform, ist das Dichtelement als O-Ring ausgebildet und zwischen der ersten Anschlussvorrichtung und dem Adapterflansch angeordnet. Derartige O-Ringe sind preiswert in der Herstellung und effektiv in ihrer Wirkung.

Um den Adapterflansch besonders zuverlässig und stabil zu fixieren, umfasst der Adapterflansch Fixiermittel, um den Adapterflansch an dem Gehäuseteil zu befestigen. Besonders einfach und effektiv eignen sich hierfür Schrauben. Die Schrauben können hierbei eine Verbindung zwischen dem Adapterflansch und der ersten Anschlussvorrichtung herstellen, jedoch wäre es ebenso denkbar, dass die Schrauben den Adapterflansch direkt mit dem Gehäuseteil oder dem Gehäuse verbinden.

In einer bevorzugten Ausführungsform, ist das Fixiermittel als manuell betätigbare Klemmvorrichtung ausgebildet. Dadurch wird beispielsweise der technische Vorteil erreicht, dass ein Wechsel des Adapterflanschs sehr schnell und ohne den Einsatz von Werkzeug möglich ist.

In einer noch weiteren bevorzugten Ausführungsform, sind die erste Anschlussvorrichtung und das Gehäuseteil einstückig als integrales Bauteil ausgebildet. Dies vereinfacht die Herstellung und die Herstellungskosten des Gehäuseteils erheblich, da weniger Einzelbauteil hergestellt und montiert werden müssen.

Gemäß einer noch weiteren bevorzugten Ausführungsform, ist die erste Anschlussvorrichtung an dem Gehäuseteil verschraubbar angeordnet. Dadurch wird beispielsweise der technische Vorteil erreicht, dass die erste Anschlussvorrichtung sehr einfach an Gehäuseteilen angeordnet werden kann. Zusätzlich kann die erste Anschlussvorrichtung von dem Gehäuseteil entfernt und ausgewechselt werden.

Um die Flexibilität und das Einsatzspektrum des Gehäuseteils zu erhöhen, weist das Gehäuseteil zumindest eine zweite Anschlussvorrichtung und einen weiteren Adapterflansch auf. Hierbei kann die zweite Anschlussvorrichtung mit dem identischen Adapterflansch verbunden werden. Ebenso ist jedoch denkbar, die erste Anschlussvorrichtung und die zweite Anschlussvorrichtung mit jeweils unterschiedlichen Adapterflanschen auszustatten. Hierbei können die unterschiedlichen Schnittstellen bedarfsgerecht auch an verschiedene Gehäuseteile eines Gehäuses für elektrische Bauteile angeordnet sein.

In einer weiteren bevorzugten Ausführungsform, ist die Anschlussvorrichtung dazu ausgebildet den Adapterflansch formschlüssig zu übergreifen. Dadurch wird der technische Vorteil erreicht, dass die innenliegende Dichtung geschützt wird und die Verbindung verschmutzungsunempfindlich und mechanisch hoch belastbar ausgeführt ist.

Um die Handhabung des Adapterflanschs und der Anschlussvorrichtung einfach und kostengünstig in Herstellung und Installation zu realisieren, sind der Adapterflansch und die Anschlussvorrichtung miteinander verrastbar ausgebildet.

Gemäß einem weiteren Aspekt der Erfindung wird die Aufgabe durch ein Verfahren zum Herstellen eines Gehäuseteils für ein Gehäuse elektrischer Bauteile mit den Schritten

Bereitstellen eines Gehäuseteils für ein Gehäuse mit einer Anschlussvorrichtung, welche als Schnittstelle zu elektrischen Bauteilen innerhalb eines Gehäuses ausgebildet ist, und Anordnen eines bestimmten Adapterflanschs aus einer Vielzahl von Adapterflanschen an die Anschlussvorrichtung, um eine bevorzugte Schnittstelle zu den elektrischen Bauteilen innerhalb eines Gehäuses herzustellen, gelöst. Dadurch wird beispielsweise der technische Vorteil erreicht, dass mit der universellen Anschlussvorrichtung in Verbindung mit einem bestimmten Adapterflansch aus einer Vielzahl von unterschiedlichen Adapterflanschen an einer einzigen Position eines Gehäuses für elektrische Bauteile jede gewünschte Schnittstelle hergestellt werden kann. Hierbei ist es besonders vorteilhaft, dass die Herstellung der entsprechenden Gehäuseteile mit einer einzigen universellen Schnittstelle preiswert und unter Einsatz weniger Werkzeugeinsätze möglich ist. Somit können die Gehäuseteile oder die Gehäuseteile werkzeugunabhängig konfektioniert werden.

Weitere Ausführungsbeispiele der Erfindung sind in den Zeichnungen dargestellt und werden im Folgenden näher beschrieben.

Es zeigen:
- Fig. 1: eine perspektivische Darstellung eines Gehäuses mit einem Gehäuseteil,
- Fig. 2: eine weitere perspektivische Darstellung eines Gehäuses mit einem Gehäuseteil,
- Fig. 3: eine weitere perspektivische Darstellung eines Gehäuses mit einem Gehäuseteil,
- Fig. 4: eine schematische Schnittdarstellung eines Gehäuses mit einem Gehäuseteil,
- Fig. 5A: eine perspektivische Darstellung einer Anschlussvorrichtung,
- Fig. 5B: eine perspektivische Darstellung eines Adapterflanschs,
- Fig. 5C: eine weitere perspektivische Darstellung eines Adapterflanschs,
- Fig. 5D: eine weitere perspektivische Darstellung eines Adapterflanschs,
- Fig. 5E: eine weitere perspektivische Darstellung eines Adapterflanschs,
- Fig. 5F: eine weitere Darstellung einer Anschlussvorrichtung,
- Fig. 6: eine weitere perspektivische Darstellung eines Gehäuses mit einem Gehäuseteil, und
- Fig. 7: eine weitere perspektivische Darstellung eines Gehäuses mit einem Gehäuseteil.

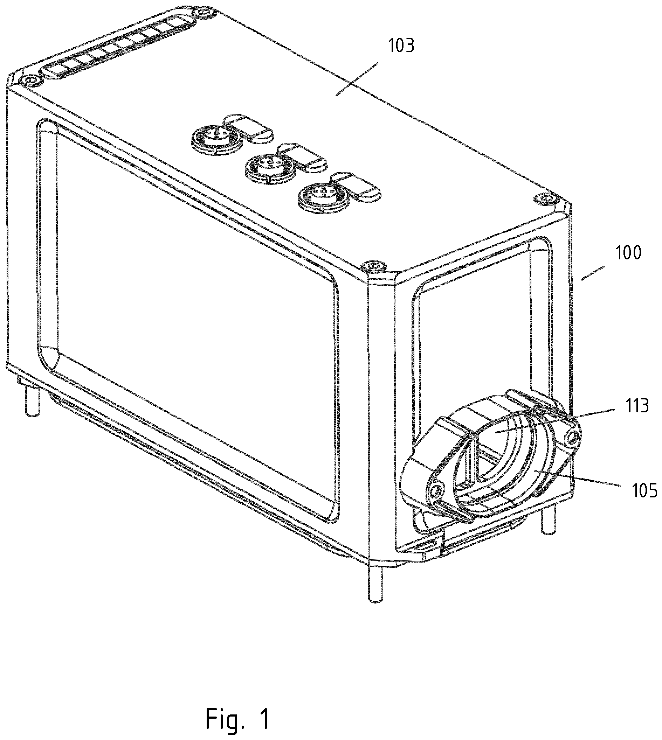

Die Figur 1 zeigt eine perspektivische Darstellung eines Gehäuses 103 mit einem Gehäuseteil 100. Das Gehäuseteil 100 ist als Teil eines Gehäuses 103 für elektrische Bauteile ausgebildet. Das Gehäuseteil 100 umfasst eine erste Anschlussvorrichtung 105, welche als Schnittstelle zu den elektrischen Bauteilen innerhalb des Gehäuses 103 ausgebildet ist. Hierbei ist die Anschlussvorrichtung 105 unmittelbar an einer Öffnung 113 angeordnet, welche beispielsweise durch Entfernen eines Knockout-Bereichs bereitgestellt wurde. Alternativ ist es jedoch ebenso möglich, dass die erste Anschlussvorrichtung 105 und das Gehäuseteil 100 einstückig als integrales Bauteil ausgebildet sind. In bestimmten Anwendungen wäre auch denkbar, die erste Anschlussvorrichtung 105 an dem Gehäuseteil 100 verschraubbar und damit leicht auswechselbar anzuordnen.

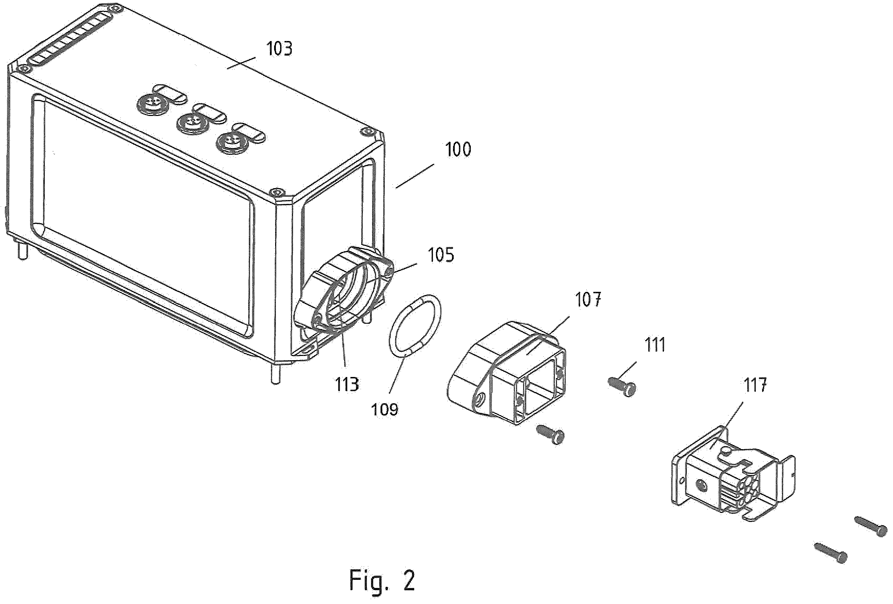

Die Figur 2 zeigt eine weitere perspektivische Darstellung eines Gehäuses 103 mit einem Gehäuseteil 100. Das Gehäuseteil 100 ist ebenso als Teil des Gehäuses 103 für elektrische Bauteile ausgebildet und umfasst die erste Anschlussvorrichtung 105 als Schnittstelle zu den elektrischen Bauteilen innerhalb des Gehäuses 103. Zusätzlich umfasst das Gehäuseteil 100 einen Adapterflansch 107, welcher zum Anordnen an die Anschlussvorrichtung 105 und als Schnittstelle zu den elektrischen Bauteilen innerhalb des Gehäuses 103 ausgebildet ist.

Der Adapterflansch 107 ist als Anbaugehäuse für einen Steckverbinder 117 ausgebildet und mittels eines Fixiermittels 111 an dem Gehäuseteil 100 befestigt. Das Fixiermittel 111 umfasst hierbei zwei Schrauben, welches alternativ beispielsweise als manuell betätigbare Klemmvorrichtung ausgebildet sein kann. Zwischen der ersten Anschlussvorrichtung 105 und dem Adapterflansch 107 ist ein Dichtelement 109 in Form eines O-Rings angeordnet. Dies verbessert die Dichtheit des Gehäuseteils 100 erheblich.

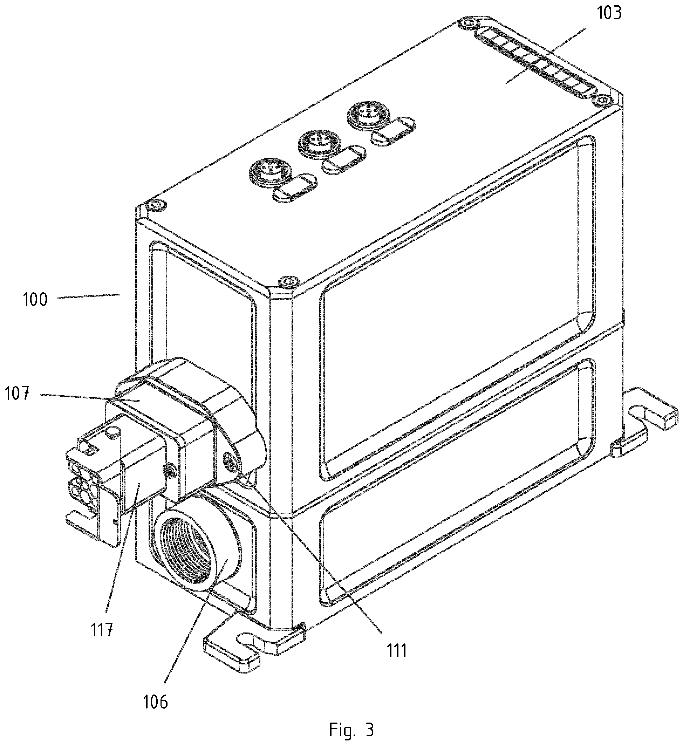

Die Figur 3 zeigt eine weitere perspektivische Darstellung eines Gehäuses 103 mit einem Gehäuseteil 100. Das Gehäuseteil 100 ist erneut Teil eines Gehäuses 103 für elektrische Bauteile und umfasst die erste Anschlussvorrichtung 105, welche als Schnittstelle zu den elektrischen Bauteilen innerhalb des Gehäuses 103 ausgebildet ist. Der Adapterflansch 107 ist als Anbaugehäuse für einen Steckverbinder 117 ausgebildet. Zusätzlich umfasst das Gehäuseteil 100 eine zweite Anschlussvorrichtung 106. Sie ist mit einem weiteren Adapterflansch 107 ausgestattet und weist ein Innengewinde auf.

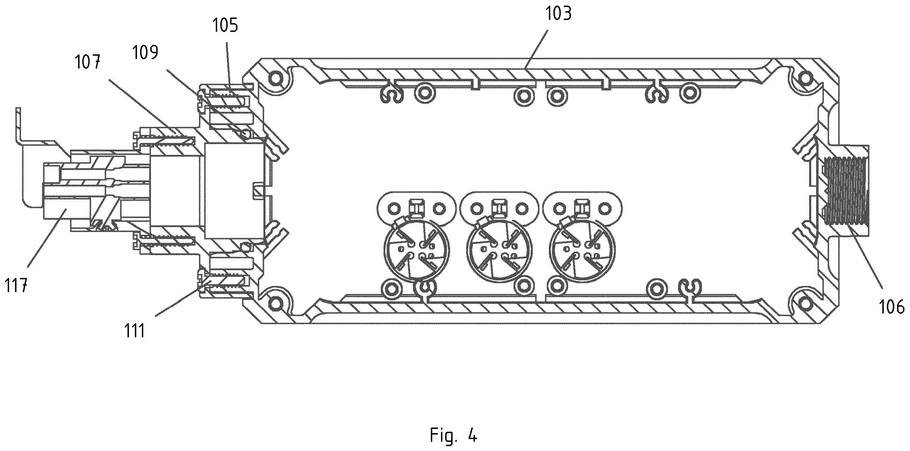

Die Figur 4 zeigt eine schematische Schnittdarstellung eines Gehäuses 103 mit einem Gehäuseteil 100. Das Gehäuseteil 100 ist erneut Teil eines Gehäuses 103 und umfasst die erste Anschlussvorrichtung 105. Der Adapterflansch 107 ist als Anbaugehäuse für einen Steckverbinder 117 ausgebildet. Zusätzlich umfasst das Gehäuse 103 eine zweite Anschlussvorrichtung 106. Sie ist an dem Gehäuse 103 auf der gegenüberliegenden Seite der ersten Anschlussvorrichtung 105 angeordnet. Zwischen der ersten Anschlussvorrichtung 105 und dem Adapterflansch 107 ist das Dichtelement 109 in Form eines O-Rings angeordnet.

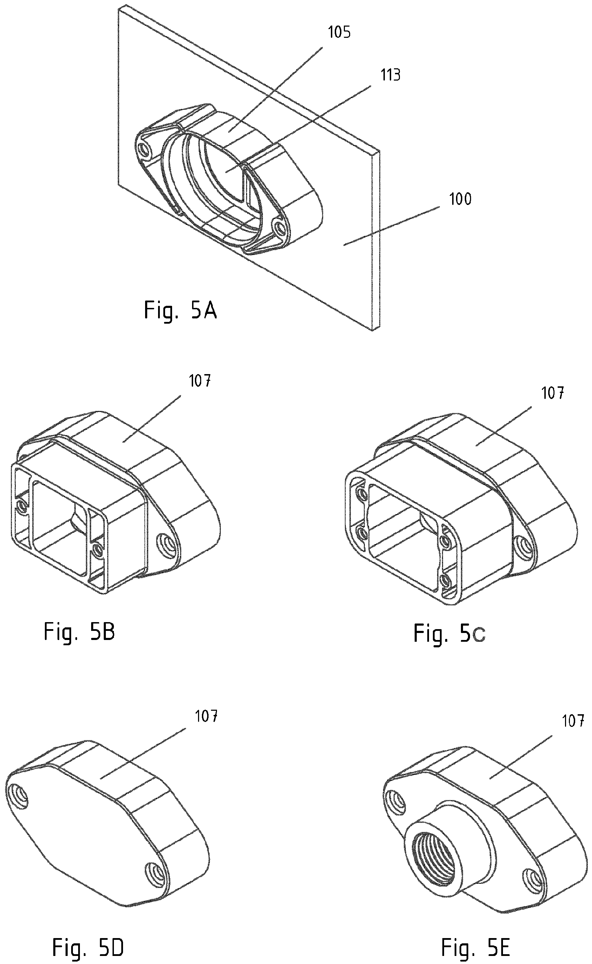

Die Figuren 5A bis 5F zeigen unterschiedliche perspektivische Darstellungen von Anschlussvorrichtungen 105 oder Adapterflanschen 107. Aufgrund der geforderten Flexibilität der Schnittstelle ist der Adapterflansch 107 austauschbar ausgebildet.

Die Figur 5A zeigt eine perspektivische Darstellung einer ersten Anschlussvorrichtung 105, wie sie an dem Gehäuseteil 100 eines Gehäuses 103 elektrischer Bauteile ausgebildet ist.

Die Figur 5B zeigt eine perspektivische Darstellung eines Adapterflanschs 107 in Form eines HanQ5 - Steckverbinders, wie er an der ersten Anschlussvorrichtung 105 angeordnet werden kann.

Die Figur 5C zeigt eine weitere perspektivische Darstellung eines Adapterflanschs 107 in Form eines HanQ8 - Steckverbinders, wie er an der ersten Anschlussvorrichtung 105 angeordnet werden kann.

Die Figur 5D zeigt eine weitere perspektivische Darstellung eines Adapterflanschs 107, welcher dazu ausgebildet ist die erste Anschlussvorrichtung 105 vollständig zu verschließen.

Die Figur 5E zeigt eine noch weitere perspektivische Darstellung eines Adapterflanschs 107, welcher einen Gewindesockel für Verschraubungen umfasst. Beispielsweise kann das Innengewinde des Gewindesockels dazu ausgebildet sein Verschraubungen der Größe M16, M20 oder M25 aufzunehmen.

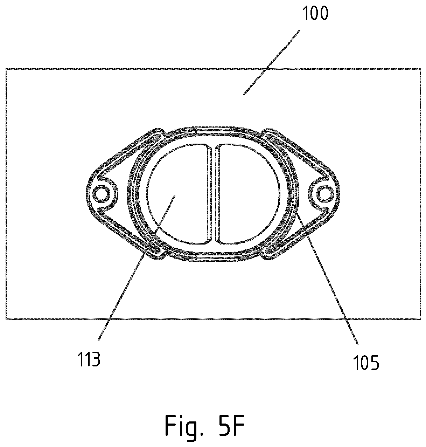

Die Figur 5F zeigt eine Darstellung einer ersten Anschlussvorrichtung 105, wie sie an dem Gehäuseteil 100 eines Gehäuses 103 elektrischer Bauteile ausgebildet ist, in einer Draufsicht.

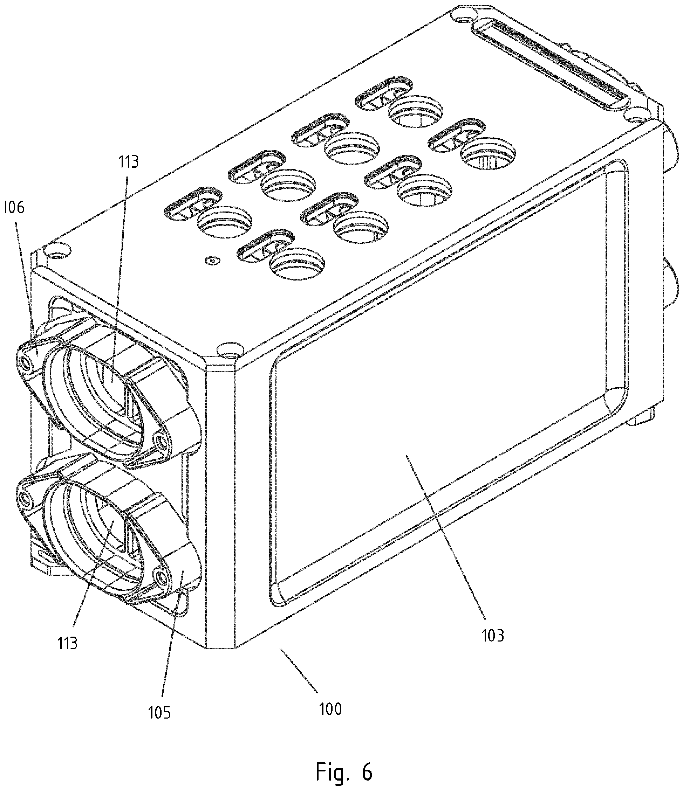

Die Figur 6 zeigt eine weitere perspektivische Darstellung eines Gehäuses 103 mit einem Gehäuseteil 100. Das Gehäuseteil 100 ist erneut Teil des Gehäuses 103 für elektrische Bauteile und umfasst die erste Anschlussvorrichtung 105, welche als Schnittstelle zu den elektrischen Bauteilen innerhalb des Gehäuses 103 ausgebildet ist. Zusätzlich umfasst das Gehäuseteil 100 eine zweite Anschlussvorrichtung 106. Die erste Anschlussvorrichtung 105 und die zweite Anschlussvorrichtung 106 sind beide parallel an dem Gehäuseteil 100 angeordnet.

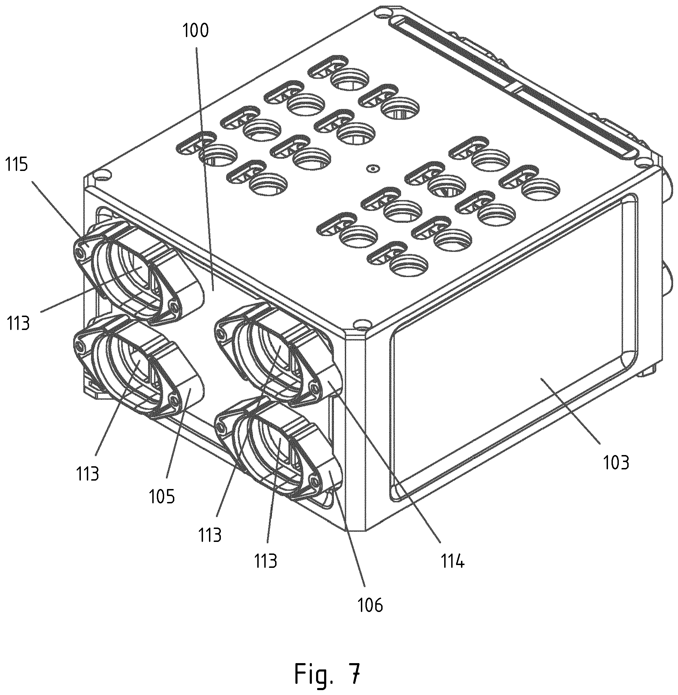

Die Figur 7 zeigt eine weitere perspektivische Darstellung eines Gehäuses 103 mit einem Gehäuseteil 100. Das Gehäuseteil 100 ist Teil des Gehäuses 103 für elektrische Bauteile und umfasst die erste Anschlussvorrichtung 105 als Schnittstelle zu den elektrischen Bauteilen innerhalb des Gehäuses 103. Zusätzlich umfasst das Gehäuseteil 100 eine zweite Anschlussvorrichtung 106, eine dritte Anschlussvorrichtung 114 und eine vierte Anschlussvorrichtung 115. Alle Anschlussvorrichtungen sind parallel an dem Gehäuseteil 100 angeordnet.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

### Bezugszeichenliste

- 100: Gehäuseteil
- 103: Gehäuse
- 105: Erste Anschlussvorrichtung
- 106: Zweite Anschlussvorrichtung
- 107: Adapterflansch
- 109: Dichtelement
- 111: Fixiermittel
- 113: Öffnung
- 114: Dritte Anschlussvorrichtung
- 115: Vierte Anschlussvorrichtung
- 117: Steckverbinder

## Patentansprüche

1. Gehäuseteil (100) für ein Gehäuse (103) elektrischer Bauteile, mit:
einer ersten universellen Anschlussvorrichtung (105), welche als Schnittstelle zu elektrischen Bauteilen innerhalb des Gehäuses (103) ausgebildet ist, und
einem anwendungsspezifischen Adapterflansch (107), welcher zum Anordnen an die erste Anschlussvorrichtung (105) und als Schnittstelle zu den elektrischen Bauteilen innerhalb des Gehäuses (103) ausgebildet ist,
wobei der Adapterflansch (107) einen Anschraubsockel für Verschraubungen umfasst.

2. Gehäuseteil (100) nach Anspruch 1, **dadurch gekennzeichnet, dass** der Adapterflansch (107) austauschbar ausgebildet ist.

3. Gehäuseteil (100) nach Anspruch 1 oder 2, **dadurch gekennzeichnet, dass** der Adapterflansch (107) dazu ausgebildet ist, metrische Anschlussverschraubungen aufzunehmen.

4. Gehäuseteil (100) nach Anspruch 1 oder 2, **dadurch gekennzeichnet, dass** der Adapterflansch (107) als Anbaugehäuse für einen Steckverbinder ausgebildet ist.

5. Gehäuseteil (100) nach einem der vorangehenden Ansprüche, **dadurch gekennzeichnet, dass** der Adapterflansch (107) dazu ausgebildet ist die erste Anschlussvorrichtung (105) vollständig zu verschließen.

6. Gehäuseteil (100) nach einem der vorangehenden Ansprüche, **dadurch gekennzeichnet, dass** das Gehäuseteil (100) ein Dichtelement (109) aufweist, um die erste Anschlussvorrichtung (105) und den Adapterflansch (107) gegeneinander abzudichten.

7. Gehäuseteil (100) nach einem der vorangehenden Ansprüche, **dadurch gekennzeichnet, dass** der Adapterflansch (107) Fixiermittel (111) umfasst, um den Adapterflansch (107) an dem Gehäuseteil (100) zu befestigen.

8. Gehäuseteil (100) nach Anspruch 7, **dadurch gekennzeichnet, dass** das Fixiermittel (111) als manuell betätigbare Klemmvorrichtung ausgebildet ist

9. Gehäuseteil (100) nach einem der vorangehenden Ansprüche, **dadurch gekennzeichnet, dass** die erste Anschlussvorrichtung (105) und das Gehäuseteil (100) einstückig als integrales Bauteil ausgebildet sind.

10. Gehäuseteil (100) nach einem der Ansprüche 1 bis 8, **dadurch gekennzeichnet, dass** die erste Anschlussvorrichtung (105) an dem Gehäuseteil (100) verschraubbar angeordnet ist.

11. Gehäuseteil (100) nach einem der vorangehenden Ansprüche, **dadurch gekennzeichnet, dass** die erste Anschlussvorrichtung (105) dazu ausgebildet ist, den Adapterflansch (107) formschlüssig zu übergreifen.

12. Gehäuseteil (100) nach einem der vorangehenden Ansprüche, **dadurch gekennzeichnet, dass** der Adapterflansch (107) und die erste Anschlussvorrichtung (105) miteinander verrastbar ausgebildet sind.

13. Gehäuseteil (100) nach einem der vorangehenden Ansprüche, **dadurch gekennzeichnet, dass** das Gehäuseteil (100) zumindest eine zweite Anschlussvorrichtung (106) und einen weiteren Adapterflansch (107) aufweist.

14. Verfahren zum Herstellen eines Gehäuseteils (100) für ein Gehäuse (103) elektrischer Bauteile nach einen der Ansprüche 1 bis 13, mit den Schritten:
Bereitstellen eines Gehäuseteils (100) für ein Gehäuse mit einer Anschlussvorrichtung (105), welche als Schnittstelle zu elektrischen Bauteilen innerhalb eines Gehäuses (103) ausgebildet ist,
Anordnen eines bestimmten Adapterflanschs (107) aus einer Vielzahl von Adapterflanschen an die Anschlussvorrichtung (105) um eine bevorzugte Schnittstelle zu den elektrischen Bauteilen innerhalb eines Gehäuses (103) herzustellen.

## Claims

1. Housing part (100) for a housing (103) of electric components, comprising:
a first universal connection device (105), which is configured as an interface to electric components inside the housing (103), and an application-specific adapter flange (107), which is configured to be arranged at the first connection device (105) and as an interface to the electric components inside the housing (103),
wherein the adapter flange (107) comprises a screw-on socket for screw connections.

2. Housing part (100) according to claim 1, **characterized in that** the adapter flange (107) is interchangeably configured.

3. Housing part (100) according to claim 1 or 2, **characterized in that** the adapter flange (107) is configured to accommodate metric connection fittings.

4. Housing part (100) according to claim 1 or 2, **characterized in that** the adapter flange (107) is configured as a mount housing for a plug connector.

5. Housing part (100) according to one of the preceding claims, **characterized in that** the adapter flange (107) is configured to completely close the first connection device (105).

6. Housing part (100) according to one of the preceding claims, **characterized in that** the housing part (100) comprises a sealing element (109) in order to seal the first connection device (105) and the adapter flange (107) from each other.

7. Housing part (100) according to one of the preceding claims, **characterized in that** the adapter flange (107) comprises fixing means (111) in order to fix the adapter flange (107) to the housing part (100).

8. Housing part (100) according to claim 7, **characterized in that** the fixing means (111) is configured as a manually operable clamping device.

9. Housing part (100) according to one of the preceding claims, **characterized in that** the first connection device (105) and the housing part (100) are configured in one piece as an integral component.

10. Housing part (100) according to one of claims 1 to 8, **characterized in that** the first connection device (105) is arranged screwable at the housing part (100).

11. Housing part (100) according to one of the preceding claims, **characterized in that** the first connection device (105) is configured to overlap the adapter flange (107) in a material manner.

12. Housing part (100) according to one of the preceding claims, **characterized in that** the adapter flange (107) and the first connection device (105) are configured in an interlockable manner to each other.

13. Housing part (100) according to one of the preceding claims, **characterized in that** the housing part (100) comprises at least a second connection device (106) and a further adapter flange (107).

14. Method for producing a housing part (100) for a housing (103) of electric components according to one of claims 1 to 13, comprising the steps:
providing a housing part (100) for a housing with a connection device (105), which is configured as an interface to electric components inside a housing (103),
arranging a specific adapter flange (107) from a plurality of adapter flanges at the connection device (105) in order to create a preferred interface to the electric components inside a housing (103).

## Revendications

1. Elément de boîtier (100) pour un boîtier (103) de composants électriques, comprenant :
un premier dispositif de raccordement universel (105) qui est réalisé en tant qu'interface avec des composants électriques à l'intérieur du boîtier (103), et
une bride d'adaptation spécifique à l'application (107) qui est réalisée pour être disposée sur le premier dispositif de raccordement (105) et est réalisée en tant qu'interface avec les composants électriques à l'intérieur du boîtier (103),
la bride d'adaptation (107) comprenant un culot à vis pour des raccords vissés.

2. Elément de boîtier (100) selon la revendication 1, **caractérisé en ce que** la bride d'adaptation (107) est réalisée de manière interchangeable.

3. Elément de boîtier (100) selon la revendication 1 ou 2, **caractérisé en ce que** la bride d'adaptation (107) est réalisée pour recevoir des raccords vissés de raccordement métriques.

4. Elément de boîtier (100) selon la revendication 1 ou 2, **caractérisé en ce que** la bride d'adaptation (107) est réalisée sous forme de boîtier rapporté pour un connecteur enfichable.

5. Elément de boîtier (100) selon l'une quelconque des revendications précédentes, **caractérisé en ce que** la bride d'adaptation (107) est réalisée pour fermer complètement le premier dispositif de raccordement (105) .

6. Elément de boîtier (100) selon l'une quelconque des revendications précédentes, **caractérisé en ce que** l'élément de boîtier (100) présente un élément d'étanchéité (109) pour rendre étanche le premier dispositif de raccordement (105) et la bride d'adaptation (107) l'un par rapport à l'autre.

7. Elément de boîtier (100) selon l'une quelconque des revendications précédentes, **caractérisé en ce que** la bride d'adaptation (107) comprend des moyens de fixation (111) pour fixer la bride d'adaptation (107) à l'élément de boîtier (100).

8. Elément de boîtier (100) selon la revendication 7, **caractérisé en ce que** le moyen de fixation (111) est réalisé en tant que dispositif de serrage à actionnement manuel.

9. Elément de boîtier (100) selon l'une quelconque des revendications précédentes, **caractérisé en ce que** le premier dispositif de raccordement (105) et l'élément de boîtier (100) sont réalisés d'un seul tenant en tant que composant intégral.

10. Elément de boîtier (100) selon l'une quelconque des revendications 1 à 8, **caractérisé en ce que** le premier dispositif de raccordement (105) est disposé sur l'élément de boîtier (100) de manière à pouvoir être vissé.

11. Elément de boîtier (100) selon l'une quelconque des revendications précédentes, **caractérisé en ce que** le premier dispositif de raccordement (105) est réalisé pour recouvrir la bride d'adaptation (107) par complémentarité de forme.

12. Elément de boîtier (100) selon l'une quelconque des revendications précédentes, **caractérisé en ce que** la bride d'adaptation (107) et le premier dispositif de raccordement (105) sont réalisés de manière à pouvoir s'enclencher l'une dans l'autre.

13. Elément de boîtier (100) selon l'une quelconque des revendications précédentes, **caractérisé en ce que** l'élément de boîtier (100) présente au moins un deuxième dispositif de raccordement (106) et une autre bride d'adaptation (107).

14. Procédé de fabrication d'un élément de boîtier (100) pour un boîtier (103) de composants électriques selon l'une quelconque des revendications 1 à 13, comprenant les étapes consistant à :
fournir un élément de boîtier (100) pour un boîtier doté d'un dispositif de raccordement (105) qui est réalisé en tant qu'interface avec des composants électriques à l'intérieur d'un boîtier (103),
disposer une certaine bride d'adaptation (107) parmi une pluralité de brides d'adaptation sur le dispositif de raccordement (105) afin d'établir une interface préférée avec les composants électriques à l'intérieur d'un boîtier (103).
